# EUROPÄISCHE PATENTSCHRIFT

(11) **EP 2 936 078 B1**
(45) Veröffentlichungstag und Bekanntmachung des Hinweises auf die Patenterteilung: **14.06.2017**
(21) Anmeldenummer: 13802348.6
(22) Anmeldetag: 06.12.2013
(51) Int. Cl.: H03L 7/099, H03L 1/02, G01D 21/00, G06F 1/08, G01D 18/00

(54) **VERFAHREN ZUR STABILISIERUNG DER TAKTFREQUENZ EINES MICROCONTROLLERS**
METHOD OF STABILIZING THE CLOCK FREQUENCY OF A MICROCONTROLLER
PROCÉDÉ DE STABILISATION DE LA FRÉQUENCE D'HORLOGE D'UN MICROCONTRÔLEUR

(30) Priorität: 19.12.2012 DE 102012112672
(43) Veröffentlichungstag der Anmeldung: 28.10.2015
(73) Patentinhaber: Endress+Hauser GmbH+Co. KG, 79689 Maulburg (DE)
(72) Erfinder: UPPENKAMP, Kaj, 79664 Wehr (DE); ROMBACH, Walter, 79618 Rheinfelden (DE); FERRARO, Franco, 79739 Schwörstadt (DE); WERNET, Armin, 79618 Rheinfelden (DE)
(74) Vertreter: Andres, Angelika Maria
(86) Internationale Anmeldenummer: PCT/EP2013/075743
(87) Internationale Veröffentlichungsnummer: WO 2014/095409

(56) Entgegenhaltungen:
- DE-A1- 2 742 908
- DE-U1-202011 052 538
- US-A1- 2004 246 809
- US-A1- 2008 136 538

## Beschreibung

Die Erfindung betrifft ein Verfahren zur Stabilisierung der Taktfrequenz eines Microcontrollers, der einem Feldgerät der Automatisierungstechnik zugeordnet ist. Bei dem Feldgerät handelt es sich bevorzugt um einen Sensor oder einen Aktor zur Bestimmung und/oder Überwachung mindestens einer Prozessgröße. Sensoren für die Prozessautomatisierungstechnik werden von der Anmelderin in vielfältigen Ausgestaltungen angeboten und vertrieben.

Sensoren (ebenso wie Aktoren) weisen üblicherweise zumindest zwei Microcontroller auf, wobei z.B. im Falle eines Sensors ein prozessseitiger Microcontroller dem Sensorelement zugeordnet und ein umformerseitiger Microcontroller dem Messumformer zugeordnet ist. In der Regel werden von dem prozessseitigen Microcontroller zum umformerseitigen Microcontroller Messdaten übertragen, welche die Prozessgröße repräsentieren, während dem umformerseitigen Microcontroller zu dem prozessseitigen Microcontroller vor allem Parametrierdaten oder sensorspezifische Kenndaten übermittelt werden. Bei der Datenübertragung bzw. der Kommunikation zwischen den beiden Microcontrollern handelt es sich üblicherweise um eine asynchrone Kommunikation. Die Kommunikation erfolgt z.B. über eine UART Schnittstelle.

Problematisch bei der asynchronen Kommunikation ist, dass die Taktfrequenz eines Microcontrollers abhängig von Temperatur- und Spannungs-Schwankungen ist. Bei zu starker relativer Drift der Taktfrequenzen der beiden Microcontroller zueinander kann daher eine asynchrone Kommunikation oder eine Zeit-/Frequenzmessung unbrauchbar werden. Daher ist es erforderlich, die intern erzeugten Taktfrequenzen der Microcontrollers stabil zu halten. Üblich ist es in diesem Zusammenhang, die Taktfrequenz bzw. den Takt eines Microcontrollers über eine zusätzliche stabile Taktfrequenz stabil zu halten. Beispielsweise wird die zusätzliche stabile Taktfrequenz von einem Uhrenquarz bereitgestellt, wobei ein Uhrenquarz sich durch eine geringere Temperaturabhängigkeit auszeichnet. Nachteilig bei der bekannten Lösung sind die Mehrkosten, die durch den zusätzlichen Uhrenquarz verursacht werden. In diesem Zusammenhang ist durch die Offenlegungsschrift DE 27 42 908 A1 ein Zeitgeber bekanntgeworden, bei dem die Temperaturabhängikeit der Ausgangsfrequenz durch Klimatisierung des Schwingquarzes erreicht wird.

Weiterhin wird für den Uhrenquarz zusätzlicher Platz benötigt, was in vielen Technikbereichen - hier in der Automatisierungstechnik - aufgrund der immer fortschreitenden Miniaturisierung der Sensoren Probleme mit sich bringt.

In der Druckschrift US 2004/0246809 A1 ist ein in Halbleiterbauweise realisierter Oszillator mit zusätzlicher Temperaturkompensation beschrieben. Ein verwandter Oszillator ist aus der US 2008/0136538 A1 bekannt: Bei dem dortigen Oszillator ist eine monolitische integrierte Temperaturkompensation gezeigt. Ein Oszillator, dessen Ausgangsfrequenz voreingestellt werden kann, wird in der Gebrauchsmusterschrift DE 20 2011 052 538 U1 thematisiert.

In dem beschriebenen Stand der Technik werden allerdings anderweitige Effekte, die zu einer unbeabsichtigten Änderung der Ausgangsfrequenz führen können, nicht thematisiert.

Der Erfindung liegt die Aufgabe zugrunde, ein Verfahren vorzuschlagen, mit dem die Taktfrequenz eines Microcontrollers effektiv stabilisiert wird.

Zwecks Stabilisierung der Taktfrequenz eines Microcontrollers, der einem Feldgerät der Automatisierungstechnik zugeordnet ist - wobei das Feldgerät in Abhängigkeit von der jeweiligen Applikation unterschiedlichen Prozessbedingungen ausgesetzt ist - wird die folgende erfindungsgemäße Lösung vorgeschlagen:
die Taktfrequenz des Microcontrollers wird bei zumindest zwei unterschiedlichen Temperaturwerten und/oder bei zumindest zwei unterschiedlichen Spannungswerten der Versorgungsspannung ermittelt,
anhand der ermittelten Werte wird die Abhängigkeit der Taktfrequenz des Microcontrollers von der Temperatur über einen vorgegebenen Temperatur- und/oder Frequenzbereich und/oder die Abhängigkeit der Taktfrequenz des Microcontrollers von der Spannung über einen vorgegebenen Spannungs- und/oder Frequenzbereich ermittelt,
die ermittelten Werte werden abgespeichert, und
der Einfluss der Temperatur und/oder der Spannung auf die Taktfrequenz des Microcontrollers werden/wird unter Berücksichtigung der ermittelten Temperaturabhängigkeit und/oder der ermittelten Spannungsabhängigkeit zumindest näherungsweise kompensiert, wobei für den Abgleichstest ein von dem Microcontroller isoliert angeordneter Frequenzgenerator eingesetzt wird, der eine Referenzfrequenz erzeugt, die zumindest näherungsweise konstant und/oder bevorzugt niedriger ist als die Taktfrequenz des Microcontrollers. Weiterhin wird die Referenzfrequenz dem Microcontroller zugeführt und als Testfrequenz gemessen, wobei die unterschiedlichen Temperaturwerte des Microcontrollers bei konstant gehaltener Spannung gemessen werden, und in dem Microcontroller die zu den unterschiedlichen Temperaturwerten gehörigen Testfrequenzen ermittelt werden. Darüber hinaus wird zumindest jeweils im Falle einer Abweichung der Testfrequenz von der Referenzfrequenz der ermittelte Testfrequenzwert und/oder eine entsprechende Frequenzänderungswert und/oder die entsprechend geänderte Taktfrequenz in Abhängigkeit von dem gemessenen Temperaturwert abgespeichert, wobei die Spannungsabhängigkeit des Microcontrollers bei Beaufschlagung des Microcontrollers mit unterschiedlichen Versorgungsspannungen ermittelt wird.

Über das erfindungsgemäße Verfahren lässt sich die Temperaturabhängigkeit und ggf. die Spannungsabhängigkeit der Taktfrequenz des Taktgebers eines Microcontrollers erheblich reduzieren. Daher wird die Güte der Kommunikation zwischen zwei Microcontrollern stark verbessert.

Gebräuchliche Microcontroller sind heute so ausgelegt, dass sie zumindest die Temperatur, insbesondere die Chip-Temperatur, eigenständig messen können. Beispielhaft sei an dieser Stelle die Microcontroller-Familie MSP430 von Texas Instruments genannt. In vielen Fällen sind die heutigen Microcontroller auch in der Lage, die Versorgungsspannung zu detektieren. Damit sind beide Störgrößen, die einen erheblichen Einfluss auf die Taktfrequenz eines Microcontrollers haben können, bekannt. Durch einen Abgleich kann der Einfluss dieser Störgrößen zumindest reduziert bzw. minimiert werden.

Im Zusammenhang mit der Erfindung ist insbesondere vorgesehen, dass die Temperaturabhängigkeit und/oder Spannungsabhängigkeit der Taktfrequenz des Microcontrollers über einen Abgleichstest während der Fertigung ermittelt werden/wird. Um die Temperaturabhängigkeit der Taktfrequenz zu ermitteln, wird der Microcontroller unterschiedlichen Temperaturen ausgesetzt; anschließend wird jeweils die gemessene Taktfrequenz in Abhängigkeit von der Temperatur gespeichert. Analog wird die Spannungsabhängigkeit der Taktfrequenz bei jeweils konstant gehaltener Temperatur ermittelt.

Gemäß einer vorteilhaften Ausführungsform werden/wird die ermittelte Temperaturabhängigkeit und/oder die ermittelte Spannungsabhängigkeit der Taktfrequenz des Microcontrollers in Tabellenform oder in Form einer Abgleichsfunktion, insbesondere im Form einer Abgleichsgeraden, gespeichert.

Gemäß einer vorteilhaften Weiterbildung des erfindungsgemäßen Verfahrens wird nicht jeder Microcontroller eines bestimmten Typs dem zuvor beschriebenen Abgleichsverfahren unterzogen. Vielmehr erfolgt die Ermittlung der Temperaturabhängigkeit und/oder der Spannungsabhängigkeit der Taktfrequenz des Microcontrollers stichprobenartig. Anschließend wird die auf diese Art und Weise ermittelte Temperaturabhängigkeit und/oder die ermittelte Spannungsabhängigkeit zur Stabilisierung der Taktfrequenz bei einer Vielzahl von gleichartigen Microcontrollern verwendet.
Wie bereits zuvor beschrieben, ist vorgesehen, dass der Microcontroller zwecks Ermittlung der Temperatur- und/oder Spannungsabhängigkeit unterschiedlichen Temperaturen ausgesetzt wird und/oder mit unterschiedlichen Spannungen beaufschlagt wird.

Für den Abgleichstest wird ein von dem Microcontroller isoliert angeordneter Frequenzgenerator eingesetzt, der eine Referenzfrequenz erzeugt, die zumindest näherungsweise konstant und/oder bevorzugt niedriger ist als die Taktfrequenz des Microcontrollers. Diese Referenzfrequenz wird dem Microcontroller zugeführt und als Testfrequenz gemessen.

Anschließend werden die unterschiedlichen Temperaturwerte des Microcontrollers bei konstant gehaltener Spannung gemessen, wobei in dem Microcontroller die zu den unterschiedlichen Temperaturwerten gehörigen Testfrequenzen ermittelt werden. Zumindest im Falle einer Abweichung der Testfrequenz von der Referenzfrequenz werden/wird der ermittelte Testfrequenzwert und/oder ein entsprechender Frequenzänderungswert und/oder die entsprechend geänderte Taktfrequenz in Abhängigkeit von dem gemessenen Temperaturwert abgespeichert.

Darüber hinaus wird die Spannungsabhängigkeit der Taktfrequenz des Microcontrollers bei Beaufschlagung des Microcontrollers mit unterschiedlichen Versorgungsspannungen ermittelt. Hierbei wird die Temperatur jeweils konstant gehalten.

Gemäß einem alternativen, nicht erfindungsgemäßen Verfahren ist vorgesehen, dass eine definierte Taktfrequenz des Microcontrollers zu einer definierten Temperatur des Microcontroller vorgegeben oder ermittelt wird, dass die definierte Taktfrequenz des Microcontrollers einem Abgleichstester zugeleitet wird, der von dem Microcontroller thermisch isoliert ist, dass der Microcontroller auf eine geänderte Temperatur gebracht wird, die von der definierten Temperatur des MicroControllers abweicht, dass einer durch die Temperaturänderung verursachten Änderung der definierten Taktfrequenz solange entgegengewirkt wird, bis die Taktfrequenz bei der geänderten Temperatur wieder der definierten Taktfrequenz entspricht, und dass die entsprechende Änderung der definierten Taktfrequenz des Microcontrollers in Abhängigkeit von der geänderten Temperatur gespeichert wird.
Darüber hinaus wird vorgeschlagen, dass die Taktfrequenz des Microcontrollers über einen Trial/Error Prozess solange geändert wird, bis die definierte Taktfrequenz wieder erreicht wird.
Um die Abhängigkeit der Taktfrequenz von beiden Störgrößen exakt ermitteln zu können, wird die Spannung während der Änderung der Temperatur des Microcontrollers konstant gehalten. Während der Änderung der Versorgungsspannung wird die Temperatur des Microcontrollers konstant gehalten. Insbesondere wird die Temperatur des Microcontrollers bestimmt, indem die Temperatur des Chips, auf dem der Microcontroller angeordnet ist, gemessen wird.
Als besonders vorteilhaft wird es im Zusammenhang mit der Erfindung erachtet, wenn der Microcontroller über einen einstellbaren Oszillator, insbesondere einen Digitally Controlled Oscillator (DCO) bzw. einen digital geregelten Oszillator getaktet wird. Der Vorteil bei der Verwendung eines DCO ist darin zu sehen, dass kein externer Taktgeber benötigt wird. Weiterhin können unterschiedliche Frequenzen eingestellt werden, und es kann während der Laufzeit eines Programms zwischen den unterschiedlichen Frequenzen umgeschaltet werden. So kann die Umschaltung beispielsweise zwischen folgenden Taktfrequenzen erfolgen: 1MHz, 8 MHz, 12 MHz und 16MHz.
Die Erfindung wird anhand der nachfolgenden Figuren näher erläutert. Es zeigt:
Fig. 1: ein Blockschaltbild, das ein erstes Verfahren zur Stabilisierung der Taktfrequenz eines Microcontrollers beschreibt,
Fig. 2: ein Blockschaltbild, das ein zweites alternatives Verfahren zur Stabilisierung der Taktfrequenz eines Microcontrollers beschreibt, und
Fig. 2a: ein Flussdiagramm, das das Verfahren zur Bestimmung der Korrekturtabelle verdeutlicht.

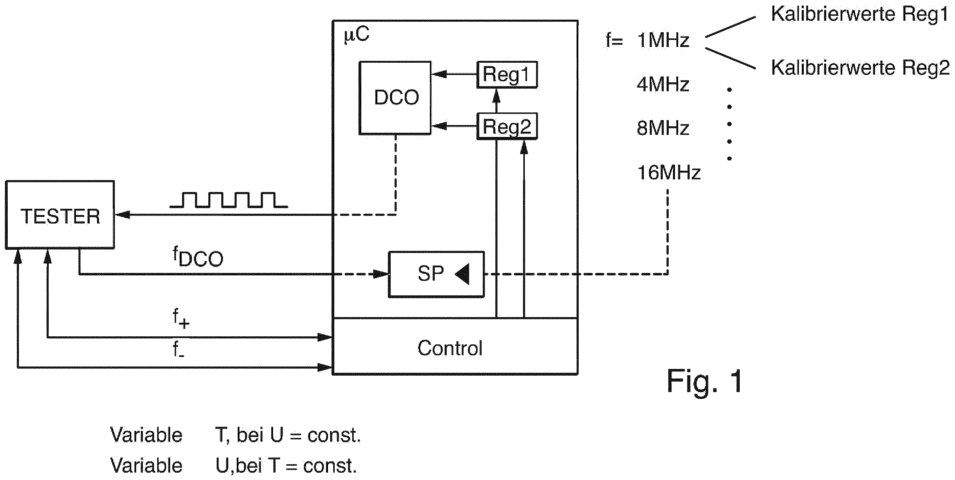

Fig. 1 zeigt ein Blockschaltbild, das ein erstes Verfahren zur Stabilisierung der Taktfrequenz eines Microcontrollers µC visualisiert. Hierzu wird eine definierte Taktfrequenz fDCO des Microcontrollers µC zu einer definierten Temperatur T1 des Microcontroller µC vorgegeben oder ermittelt. Im gezeigten Fall wird der Microcontroller µC über einen einstellbaren Oszillator DCO bzw. einen internen Taktgeber DCO, insbesondere einen Digitally Controlled Oscillator DCO getaktet. Über den einstellbaren Oszillator DCO können unterschiedliche Taktfrequenzen f eingestellt werden, hier 1 MHz, 4MHz, 8MHz, 16MHz.

Die definierte Taktfrequenz fDCO (z.B. 1 MHz) des Microcontrollers µC wird einem Abgleichstester TESTER zugeleitet, der von dem Microcontroller µC thermisch isoliert ist. Anschließend wird der Microcontroller µC auf eine geänderte Temperatur T2 gebracht, die von der definierten Temperatur T1 des MicroControllers µC abweicht. Einer durch die Temperaturänderung T2-T1 verursachten Änderung der definierten Taktfrequenz fDCO wird solange entgegengewirkt, bis die Taktfrequenz des Microcontrollers µC bei der geänderten Temperatur T2 wieder der definierten Taktfrequenz fDCO entspricht. Bevorzugt wird die Taktfrequenz fDCO des Microcontrollers µC über eine Steuerung CONTROL in einem Trial/Error Prozess solange geändert, bis die definierte Taktfrequenz fDCO wieder erreicht wird. Die zu den einzelnen Temperaturwerten T1, T2, .. während der Testphase ermittelten Frequenzwerte bzw. die Frequenzänderungswerte werden von der Steuerung CONTROL in den Speicher SP geschrieben. In Abhängigkeit von den gemessenen Temperaturwerten T1, T2, ... schreibt die Steuerung CONTROL nachfolgend während der Betriebsphase des Microcontrollers µC die ermittelten Frequenzwerte bzw. Frequenzänderungswerte in die Register Reg1, Reg2, .., die den einstellbaren Oszillator DCO entsprechend ansteuern.

Während des Temperaturänderungsverfahrens in der Testphase wird die Spannung U des Microcontrollers µC konstant gehalten. Bevorzugt wird für die Temperaturbestimmung des Microcontrollers µC die Temperatur des Chips, auf dem der Microcontroller µC angeordnet ist, gemessen. Analog wird die Abhängigkeit der Frequenz des Microcontrollers µC von Änderungen der Versorgungsspannung U1, U2, .. während der Testphase ermittelt, so dass ggf. auch eine entsprechende von der Versorgungsspannung U1, U2, .. abhängige Frequenzanpassung während der Betriebsphase erfolgen kann.

In der Testphase wird der Frequenzabgleich bevorzugt über einen Trial/Error Prozess durchgeführt. Dies ist in Fig. 1 über die Frequenzangaben f+, f- dargestellt. Die in Abhängigkeit von der Temperatur T ermittelten Änderungen der Taktfrequenz FDCO werden in Abhängigkeit von den gemessenen Temperaturwerten T1, T2, ... in der Speichereinheit SP gespeichert. Im einfachsten Fall werden Zwischenwerte über eine Abgleichsgerade oder eine Abgleichfunktion ermittelt. Der Abgleichstest in der Testphase erfolgt bevorzugt während des Fertigungsverfahrens.

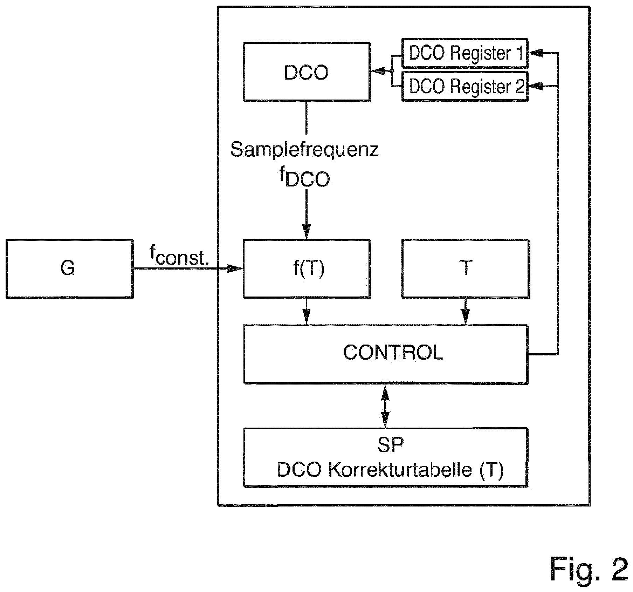

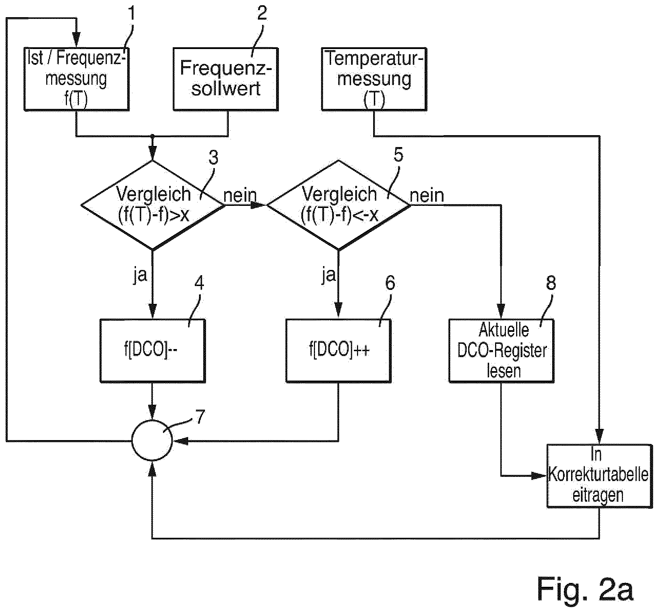

In Fig. 2 ist ein Blockschaltbild zu sehen, das ein alternatives Verfahren zur Stabilisierung der Taktfrequenz eines Microcontrollers µC visualisiert. Für den Abgleichstest, der bevorzugt wieder während der Fertigungsphase durchgeführt wird, wird ein von dem Microcontroller µC thermisch isoliert angeordneter Frequenzgenerator bzw. externer Taktgenerator G eingesetzt. Der Frequenzgenerator G erzeugt eine Referenzfrequenz fconst, die zumindest näherungsweise konstant ist. Bevorzugt ist die Referenzfrequenz fconst niedriger als die Samplefrequenz f des Microcontrollers µC. Die Referenzfrequenz fconst wird dem Microcontroller µC zugeführt und im Microcontroller µC mittels eines Frequenzmessers FM als Testfrequenz f(T) gemessen. Die gemessene Testfrequenz f(T) wird in Abhängigkeit von der jeweils gemessenen Temperatur T in dem Speicher SP in einer Korrekturtabelle abgespeichert.

Anschließend wird der Microcontroller µC während des Ablgeichstests mehreren unterschiedlichen Temperaturwerten T1, T2, ... ausgesetzt. Die Temperaturwerte T1, T2, .. des Microcontrollers µC werden bei konstant gehaltener Spannung U gemessen. Als Temperatur T des Microcontrollers µC wird bevorzugt die Chiptemperatur genommen. In dem Microcontroller µC werden die zu den unterschiedlichen Temperaturwerten T1, T2, ... gehörigen Testfrequenzen f(T1), f(T2), ... ermittelt. Im Falle einer Abweichung der Testfrequenz f(T) von der Referenzfrequenz fconst werden die ermittelten Testfrequenzen f(T1), f(T2), .. und/oder die entsprechenden Frequenzänderungswerte und/oder die entsprechend geänderten Taktfrequenzen bzw. Samplefrequenzen in Abhängigkeit von den gemessenen Temperaturwerten T1, T2, ... abgespeichert. Ein analoger Abgleichstest wird anschließend für die Ermittlung der Spannungs-abhängigkeit des Microcontrollers µC durchgeführt. Hierzu wird der Microcontroller µC bei konstant gehaltener Temperatur T mit unterschiedlichen Versorgungsspannungen U1, U2, ... beaufschlagt.

Während der späteren Betriebsphase des Microcontrollers µC werden/wird die vorab bestimmten Temperatur- und/oder Spannungsabhängigkeit des Microcontrollers µC, die üblicherweise in einer Korrekturtabelle gespeichert sind, zur Korrektur der Taktfrequenz fDCO verwendet.

In Fig. 2a ist ein Flussdiagramm zu sehen, das das Verfahren zur Ermittlung der Werte der Korrekturtabelle während der Testphase verdeutlicht. Die unter Punkt 1 gemessene Frequenz f(T) und der unter Punkt 2 vorgegebene Frequenzsollwert fconst werden unter dem Programmpunkt 3 miteinander verglichen. Ist die Differenz zwischen der gemessenen Frequenz f(T) und dem vorgegebene Frequenzsollwert fconst größer als ein vorgegebener Wert x, so wird bei Punkt 4 die Frequenz des internen Taktgebers bzw. des Oszillators DCO herabgesetzt. Ist die Differenz zwischen der gemessenen Frequenz f(T) und dem vorgegebene Frequenzsollwert fconst kleiner als der negative vorgegebene Wert x, was bei Punkt 5 geprüft wird, so wird die Frequenz fDCO des Taktgebers DCO bei Punkt 6 heraufgesetzt. Werden beide Prüfungen unter Punkt 3 und Punkt 5 verneint, so wird unter Punkt 8 das aktuelle Register des internen Taktgebers DCO gelesen. Der ermittelte Frequenzwert fDCO wird in Abhängigkeit von der Temperatur T in der Korrekturtabelle gespeichert. Während einer nachfolgenden Betriebsphase des Microcontrollers µC werden die ermittelten temperaturabhängigen Frequenzwerte f(T1), f(T2), ... zur Ansteuerung des Taktgebers DCO verwendet. Hierbei wird die Temperatur T des Microcontrollers µC bevorzugt auf dem Chip gemessen, auf dem der Microcontroller µC angeordnet ist.

## Patentansprüche

1. Verfahren zur Stabilisierung der Taktfrequenz (f) eines Microcontrollers, der einem Feldgerät der Automatisierungstechnik zugeordnet ist, wobei das Feldgerät in Abhängigkeit von der Applikation unterschiedlichen Prozessbedingungen ausgesetzt ist, wobei die Taktfrequenz (f) des Microcontrollers (µC) bei zumindest zwei unterschiedlichen Temperaturwerten (T1, T2, ..) und/oder bei zumindest zwei unterschiedlichen Spannungswerten (U1, U2, ..) ermittelt wird,
wobei anhand der ermittelten Werte die Abhängigkeit der Taktfrequenz (f) des Microcontrollers (µC) von der Temperatur (T) über einen vorgegebenen Temperatur- und/oder Frequenzbereich und/oder die Abhängigkeit der Taktfrequenz (f) des Microcontrollers (µC) von der Spannung (U) über einen vorgegebenen Spannungs- und/oder Frequenzbereich ermittelt wird,
wobei die ermittelten Werte abgespeichert werden, und
wobei der Einfluss der Temperatur (T) und/oder der Spannung (U) auf die Taktfrequenz (f) des Microcontrollers (µC) unter Berücksichtigung der ermittelten Temperaturabhängigkeit und/oder der ermittelten Spannungsabhängigkeit zumindest näherungsweise kompensiert werden/wird,
wobei für den Abgleichstest ein von dem Microcontroller (µC) isoliert angeordneter Frequenzgenerator (G) eingesetzt wird, der eine Referenzfrequenz (fconst) erzeugt, die zumindest näherungsweise konstant und/oder bevorzugt niedriger ist als die Taktfrequenz (f) des Microcontrollers (µC), und
wobei die Referenzfrequenz (fconst) dem Microcontroller (µC) zugeführt und als Testfrequenz (ft) gemessen wird,
wobei die unterschiedlichen Temperaturwerte des Microcontrollers (µC) bei konstant gehaltener Spannung (U) gemessen werden,
wobei in dem Microcontroller (µC) die zu den unterschiedlichen Temperaturwerten (T1, T2, ...) gehörigen Testfrequenzen (f(T)) ermittelt werden, und
wobei zumindest jeweils im Falle einer Abweichung der Testfrequenz (ft) von der Referenzfrequenz (fconst) der ermittelte Testfrequenzwert (ft) und/oder eine entsprechende Frequenzänderungswert und/oder die entsprechend geänderte Taktfrequenz in Abhängigkeit von dem gemessenen Temperaturwert (T) abgespeichert wird, und
wobei die Spannungsabhängigkeit der Taktfrequenz des Microcontrollers (µC) bei Beaufschlagung des Microcontrollers (µC) mit unterschiedlichen Versorgungsspannungen (U1, U2, ...) ermittelt wird.

2. Verfahren nach Anspruch 1,
wobei die Temperaturabhängigkeit und/oder Spannungsabhängigkeit der Taktfrequenz (f) des Microcontrollers (µC) über einen Abgleichstest während der Fertigung ermittelt werden/wird.

3. Verfahren nach Anspruch 1 oder 2,
wobei die ermittelte Temperaturabhängigkeit und/oder die ermittelte Spannungsabhängigkeit der Taktfrequenz (f) des Microcontrollers (µC) in Tabellenform oder in Form einer Abgleichsfunktion, insbesondere einer Abgleichsgeraden, gespeichert werden/wird.

4. Verfahren nach Anspruch 1, 2 oder 3,
wobei die Ermittlung der Temperaturabhängigkeit und/oder der Spannungsabhängigkeit der Taktfrequenz des Microcontrollers (µC) stichprobenartig erfolgt und wobei die ermittelte Temperaturabhängigkeit und/oder die ermittelte Spannungsabhängigkeit zur Stabilisierung der Taktfrequenz (f) bei einer Vielzahl von gleichartigen Microcontrollern (µC) verwendet wird.

5. Verfahren nach einem oder mehreren der vorhergehenden Ansprüche,
wobei der Microcontrollers (µC) zwecks Ermittlung der Temperatur- und/oder Spannungsabhängigkeit unterschiedlichen Temperaturen (T1, T2, ...) ausgesetzt wird und/oder mit unterschiedlichen Spannungen (U 1, U2, ...) beaufschlagt wird.

6. Verfahren nach einem oder mehreren der vorhergehenden Ansprüche, wobei zur Bestimmung der Temperatur (T) des Microcontrollers (µC) die Temperatur des Chips, auf dem der Microcontroller (µC) angeordnet ist, gemessen wird.

7. Verfahren nach einem oder mehreren der vorhergehenden Ansprüche, wobei der Microcontroller über einen einstellbaren Oszillator (DCO), insbesondere einen Digitally Controlled Oscillator (DCO), getaktet wird.

## Claims

1. Procedure designed to stabilize the clock frequency (f) of a microcontroller, which is assigned to an automation engineering field device, wherein the field device is subject to different process conditions depending on the application, wherein the clock frequency (f) of the microcontroller (µC) is determined at at least two different temperature values (T1, T2, ...) and/or at at least two different voltage values (U1, U2, ...),
wherein, on the basis of the values determined, the dependency of the clock frequency of the microcontroller (µC) on the temperature (T) is determined over a predefined temperature range and/or frequency range and/or the dependency of the clock frequency (f) of the microcontroller (µC) on the voltage (U) is determined over a predefined voltage range and/or frequency range,
wherein the values determined are saved, and
wherein the influence of the temperature (T) and/or the voltage (U) on the clock frequency (f) of the microcontroller (µC) is/are at least approximately compensated for taking into account the determined temperature dependency and/or the determined voltage dependency,
wherein a frequency generator (G), which is arranged in a manner that it is isolated from the microcontroller (µC), is used for the concordance test, said frequency generator generating a reference frequency (fconst), which is at least approximately constant and/or preferably lower than the clock frequency of the microcontroller (µC), and
wherein the reference frequency (fconst) is supplied to the microcontroller (µC) and measured as the test frequency (ft),
wherein the different temperature values of the microcontroller (µC) are measured at a voltage (U) that is held constant,
wherein the test frequencies (f(T)), which correspond to the different temperature values (T1, T2, ...), are determined in the microcontroller (µC), and wherein at least in situations where the test frequency (ft) deviates from the reference frequency (fconst), the determined test frequency value (ft) and/or a corresponding frequency change value and/or the clock frequency which has changed accordingly are saved depending on the measured temperature value (T), and
wherein the voltage dependency of the clock frequency of the microcontroller (µC) is determined when different supply voltages (U1, U2, ...) are applied to the microcontroller (µC).

2. Procedure as claimed in Claim 1,
wherein the temperature dependency and/ the voltage dependency of the clock frequency (f) of the microcontroller (µC) is/are determined by a concordance test during the production process.

3. Procedure as claimed in Claim 1 or 2,
wherein the determined temperature dependency and/ the determined voltage dependency of the clock frequency (f) of the microcontroller (µC) is/are saved in tabular form or in the form of a concordance function, particularly a concordance line.

4. Procedure as claimed in Claim 1, 2 or 3,
wherein the temperature dependency and/or the voltage dependency of the clock frequency of the microcontroller (µC) is determined at random, and wherein the determined temperature dependency and/ the determined voltage dependency is/are used to stabilize the clock frequency (f) for a large number of similar microcontrollers (µC).

5. Procedure as claimed in one or more of the previous claims, wherein the microcontroller (µC) is exposed to different temperatures (T1, T2, ...) and/or different voltages (U1, U2, ...) for the purpose of determining the temperature dependency and/or voltage dependency.

6. Procedure as claimed in one or more of the previous claims, wherein the temperature of the chip on which the microcontroller (µC) is arranged is measured for the purpose of determining the temperature (T) of the microcontroller (µC).

7. Procedure as claimed in one or more of the previous claims, wherein the microcontroller is clocked via a controllable oscillator, particularly a digitally controlled oscillator (DCO).

## Revendications

1. Procédé destiné à la stabilisation d'une fréquence d'horloge (f) d'un microcontrôleur, qui est attribué à un appareil de terrain de la technique d'automatisation, l'appareil de terrain étant exposé, selon l'application, à différentes conditions de process, la fréquence d'horloge (f) du microcontrôleur (µC) étant déterminée à au moins deux valeurs de température (T1, T2, ...) et/ou à au moins deux valeurs de tension (U1, U2, ...),
pour lequel sont déterminées, au moyen des valeurs déterminées, la dépendance en température (T) de la fréquence d'horloge du microcontrôleur (µC) sur une gamme de température et/ou de fréquence prédéfinie et/ou la dépendance en tension (U) de la fréquence d'horloge du microcontrôleur (µC) sur une gamme de tension et/ou de fréquence prédéfinie,
les valeurs déterminées étant enregistrées, et
l'influence de la température (T) et/ou de la tension (U) sur la fréquence d'horloge (f) du microcontrôleur (µC) étant au moins approximativement compensée en tenant compte de la dépendance en température déterminée et/ou la dépendance en tension déterminée,
un générateur de fréquence (G) disposé de façon isolée du microcontrôleur (µC) étant utilisé pour le test de concordance, lequel générateur génère une fréquence de référence (fconst), qui est au moins approximativement constante et/ou de préférence inférieure à la fréquence d'horloge du microcontrôleur (µC), et
la fréquence de référence (fconst) étant acheminée au microcontrôleur (µC) et mesurée en tant que fréquence de test (ft),
les différentes valeurs de température du microcontrôleur (µC) étant mesurées à une tension (U) maintenue constante,
les fréquences de test (f(T)), qui correspondent aux différentes valeurs de température (T1, T2, ...), étant déterminées dans le microcontrôleur (µC), et procédé pour lequel, en cas d'écart de la fréquence de test (ft) par rapport à la fréquence de référence (fconst), la valeur de fréquence de test (ft) déterminée et/ou une valeur de changement de fréquence correspondante et/ou la fréquence d'horloge modifiée en conséquence sont enregistrées en fonction de la valeur de température (T) mesurée, et
la dépendance en tension de la fréquence d'horloge du microcontrôleur (µC) étant déterminée en alimentant le microcontrôleur (µC) avec différentes tensions d'alimentation (U1, U2, ...).

2. Procédé selon la revendication 1,
pour lequel la dépendance en température déterminée et/ou la dépendance en tension déterminée de la fréquence d'horloge (f) du microcontrôleur (µC) sont déterminées au moyen d'un test de concordance pendant la fabrication.

3. Procédé selon la revendication 1 ou 2,
pour lequel la dépendance en température déterminée et/ou la dépendance en tension déterminée de la fréquence d'horloge (f) du microcontrôleur (µC) sont enregistrées sous forme tabellaire ou sous la forme d'une fonction de concordance, notamment d'une droite de concordance.

4. Procédé selon la revendication 1, 2 ou 3,
pour lequel la détermination de la dépendance en température et/ou de la dépendance en tension de la fréquence d'horloge du microcontrôleur (µC) est effectuée au hasard et pour lequel la dépendance en température déterminée et/ou la dépendance en tension déterminée sont utilisées en vue de la stabilisation de la fréquence d'horloge (f) pour un grand nombre de microcontrôleurs (µC) similaires.

5. Procédé selon l'une ou plusieurs des revendications précédentes, pour lequel le microcontrôleur (µC) est exposé à différentes températures (T1, T2, ...) et/ou à différentes tensions (U1, U2, ...) en vue de la détermination de la dépendance en température et/ou en tension.

6. Procédé selon l'une ou plusieurs des revendications précédentes, pour lequel la température de la puce, sur laquelle le microcontrôleur (µC) est disposé, est mesurée en vue de la détermination de la température (T) du microcontrôleur (µC).

7. Procédé selon l'une ou plusieurs des revendications précédentes, pour lequel le microcontrôleur est cadencé au moyen d'un oscillateur réglable (DCO), notamment un oscillateur à commande numérique (DCO - Digitally Controlled Oscillator).
